# EUROPEAN PATENT APPLICATION

(11) **EP 3 328 168 A1**
(43) Date of publication of application: **30.05.2018**
(21) Application number: 16382556.5
(22) Date of filing: 24.11.2016
(51) Int. Cl.: H05K 3/14

(54) **METHOD FOR CREATING AN ELECTRONIC ASSEMBLY AND ELECTRONIC ASSEMBLY**

(71) Applicant: VALEO ILUMINACION, 23600 Martos (ES)
(72) Inventor: TEBA, Daniel, 23600 Martos (Jaen) (ES); GUZMAN, Alfonso-Manuel, 23560 Huelma (Jaen) (ES); MARTINEZ, Francisco, 18500 Guadix (Granada) (ES)

(57) **Abstract**

The invention provides for a method for creating an electronic assembly (1). The method comprises the steps of: providing a plastics substrate (2), providing a semiconductor light source (5), depositing a conductive track (3) by direct deposition on the plastics substrate (2), depositing a conductive welding material (4) on the conductive track (3) or on the light source (5), placing the light source (5) on the conductive track (3) in such a way that the conductive welding material (4) is in direct contact with both the conductive track (3) and the light source (5), and finally addressing a heat source on the conductive welding material, so that an electric contact between the light source and the conductive track is achieved by means of the conductive welding material (4), thereby obtaining the electronic assembly. The invention also includes an electronic assembly and a lighting device.

## Description

### TECHNICAL FIELD

The present invention belongs to the field of electronic assemblies comprising conductive tracks directly deposited on a plastics substrate.

### STATE OF THE ART

Directly depositing a conductive track on a plastics substrate normally supposes substantial cost savings, mainly due to the fact that a dedicated printed circuit board need not be provided. Therefore, other integral parts of the device to be controlled with the electronic assembly can be taken advantage of to play the role of substrate for the conductive track.

Furthermore, the process of direct deposition of the conductive track usually implies shorter manufacturing times and conductive material savings - in contrast to most PCB manufacturing methods, there is no need for removing regions of conductive material or for using an additional product, such as an electrolyte, to define the conductive track.

Welding and curing is a known method to place a semiconductor light source, such as a high power light emitting diode (LED) in a printed circuit board (PCB). However, when a high power LED is to be attached to a conductive track directly deposited on a plastics substrate, standard welding and curing may degrade the plastics substrate.

### DESCRIPTION OF THE INVENTION

The invention provides a solution for this problem by means of a method for creating an electronic assembly according to claim 1, an electronic assembly according to claim 9 and a lighting device according to claim 14. Preferred embodiments of the invention are defined in dependent claims.

In an inventive aspect, the invention provides a method for creating an electronic assembly, the method comprising the steps of:
providing a plastics substrate;
providing a semiconductor light source;
depositing a conductive track by direct deposition on the plastics substrate;
depositing a conductive welding material on the conductive track or on the light source;
placing the light source on the conductive track, in such a way that the conductive welding material is in direct contact with both the conductive track and the light source; and
addressing a heat source on the conductive welding material, so that an electric contact between the light source and the conductive track is achieved by means of the conductive welding material, thereby obtaining the electronic assembly.

Direct deposition of a conductive track on a plastics substrate should be construed as forming the final shape of the conductive track on the plastics substrate without the need for removing metal or for any other intermediate element, such as a mask, an electrolyte or any other chemical bath or a photosensitive film. The conductive track is just directly placed on the plastics substrate.

This method advantageously achieves the electric connection of a semiconductor light source to a conductive track directly deposited on a three-dimensional plastics substrate. In some particular embodiments, the plastics substrate is a three-dimensional plastics substrate.

In some particular embodiments, the heat source comprises a gas flow, which is addressed by using a gas nozzle.

This method is a particularly advantageous way of addressing the heat source, further providing an easy and effective way of providing multiple heat sources just by connecting multiples nozzles to a main chamber.

In some particular embodiments, the method according to the invention further comprises the step of depositing a drop of an adhesive material between the light source and the conductive track.

This method advantageously provides the possibility of using a greater airflow, since the adhesive prevents the light source from being swept away by the airflow.

In some particular embodiments, the method according to the invention further comprises the step of placing a barrier at least partially surrounding the conductive welding material, the barrier being intended to block any substance which is generated during the method.

This particular method advantageously provides a way of avoiding that some substances, which may be separated from the conductive welding material when it is cured, reach some dangerous locations in the electronic assembly, such as other conductive tracks.

In some particular embodiments, the conductive welding material is either a conductive glue or a welding paste.

These two ways have proven to be particularly advantageous for providing the conductive welding material.

In some particular embodiments, the light source is a semiconductor light source, such as a LED or a laser light.

This method suits particularly well to semiconductor light sources, such as LEDs or laser lights, because the absence of printed circuit boards makes the electronic assembly according to the invention very compact, and semiconductor light sources usually takes advantages of this compactness.

In some particular embodiments, the step of depositing a conductive track by direct deposition on the plastics substrate is carried out by means of a plasma flow containing metal dust particles.

This is an easy and very effective way of directly depositing a conductive track on a plastics substrate. This step may be carried out, for instance, using the device described in document US 2015/174686 A1, and concretely in its claim 1.

In another inventive aspect, the invention provides an electronic assembly manufactured by a method according to the previous inventive aspect.

Such an electronic assembly advantageously provides an electric connection of a semiconductor light source to a conductive track directly deposited on a three-dimensional plastics substrate.

In another inventive aspect, the invention provides an electronic assembly comprising
a semiconductor light source;
a plastics substrate;
a conductive track created by direct deposition on the plastics substrate;
a conductive welding material arranged on the conductive track, the conductive welding material being in direct contact with both the conductive track and the light source.

This electronic assembly advantageously includes an electric connection of a semiconductor light source to a conductive track which has been directly deposited on a three-dimensional plastics substrate.

In some particular embodiments, the conductive welding material is either a conductive glue or a welding paste.

These two ways have proven to be the best ways in which the conductive welding material may be provided.

In some particular embodiments, the conductive welding material comprises at least one of Cu, Al, Sn, Bi or Ag.

These elements have good properties for creating a solid and conductive connection between the light source and the conductive track.

In some particular embodiments, the semiconductor light source is a LED or a laser light source.

Semiconductor light sources, such as LEDs or laser light sources have proved to be very efficient for automotive applications.

In some particular embodiments, the plastics substrate is three-dimensional.

A three-dimensional plastics substrate should be construed as a plastics substrate whose surface on which the conductive track extends is not completely contained in a plane. Direct deposition is particularly appropriate for such three-dimensional surfaces, in comparison to other known techniques which normally require planar surfaces for printing a circuit board.

This device is suitable for being used in several applications, where a three-dimensional plastics substrate is required to provide lighting in a more complex environment.

In another inventive aspect, the invention provides a lighting device for an automotive vehicle comprising
an electronic assembly according to the previous inventive aspect;
an optical element suitable for receiving light emitted by the light source and for shaping light into a light pattern projected outside the lighting device; and
a housing accommodating the electronic assembly and the optical element.

An optical element is an element that has some optical properties to receive a light beam and emit it in a certain direction and/or shape, as a person skilled in automotive lighting would construe without any additional burden. Reflectors, collimators, light guides, projection lenses, etc., or the combination thereof are some examples of these optical elements.

Lighting devices for automotive vehicles can benefit from the use of electronic assemblies comprising conductive tracks directly deposited on a plastics substrate. In the first place, a wide range of the lighting device's parts can be used either as plastics substrate or as base for the plastics substrate (in which case the plastics substrate may for instance coat the base), taking into account that even three-dimensional plastics substrates are suitable for direct deposition of conductive tracks. Therefore, a dedicated printed board circuit is not required, which leads to reducing the cost and the weight of the lighting device. As was stated above, cost savings are even more significant due to the fact that direct deposition does not normally want removing conductive material to shape the conductive tracks.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figures 1a to 1c show some steps of a method for creating an electronic assembly according to the invention.
Figure 2 shows an electronic assembly according to the invention.
Figure 3 shows a lighting device comprising an electronic assembly as shown in figure 2.

### DETAILED DESCRIPTION OF THE INVENTION

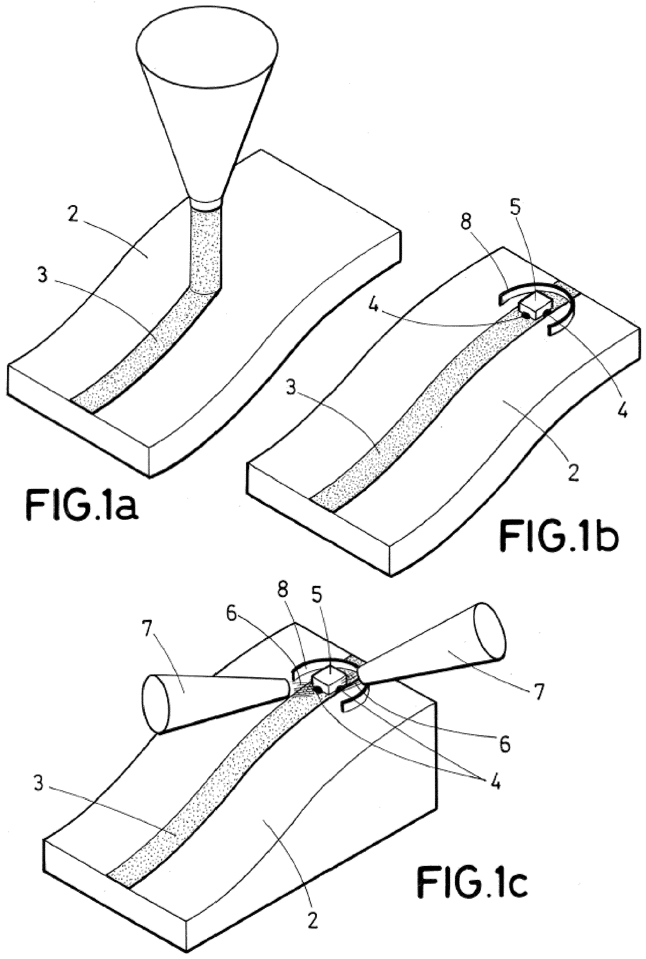

Figures 1a to 1c show some steps of a method for creating an electronic assembly according to the invention. This method comprises the steps of:
providing a three-dimensional plastics substrate 2;
providing a semiconductor light source 5, such as a LED or a laser light;
depositing a conductive track 3 directly on the three-dimensional plastics substrate 2;
placing a barrier 8 at least partially surrounding the conductive welding material 4, the barrier 8 being intended to block any substance which is generated during the method.
depositing a conductive welding material 4 on the conductive track 3 or on the semiconductor light source 5;
placing the semiconductor light source 5 on the conductive track 3, in such a way that the conductive welding material 4 is in direct contact with both the conductive track 3 and the semiconductor light source 5; and
addressing a gas flow 6 on the conductive welding material using a gas nozzle 7, so that an electric contact between the semiconductor light source 5 and the conductive track 3 is achieved by means of the conductive welding material 4, thereby obtaining the electronic assembly 1.

Figure 1a shows the three first steps of this method. A conductive track 3 is being directly deposited on a three-dimensional plastics substrate 2. In some embodiments, as shown in this figure, this direct deposition may be carried out by means of a plasma nozzle which ejects a plasma flow containing dust particles of a conductive metal. These metal dust particles solidify when contacting the plastics substrate 2, thus creating a conductive track 3 on this plastics substrate 2. When the plasma nozzle ends this operation, the conductive track 3 is ready to be used.

Figure 1b shows the next three steps of this method. Firstly, a barrier 8 is placed surrounding the conductive welding material 4. Then, a piece of conductive welding material 4 is deposited on the conductive track 3 or on the semiconductor light source 5. It is not relevant if this piece of conductive welding material 4 is deposited on one element or on the other, as the relevant issue is that the semiconductor light source 5 is afterwards placed over the conductive track 3 in such a way that the piece of conductive welding material 4 is in direct contact with both the conductive track 3 and the semiconductor light source 5. The piece of conductive welding material 4 attaches the semiconductor light source 5 and the conductive track 3, on the one hand as a bonding element and on the other hand as an electrical connection element.

Figure 1c shows the last step of this method. A gas flow 6 on the conductive welding material using a gas nozzle 7, curing the conductive welding material 4 so that an electric contact between the semiconductor light source 5 and the conductive track 3 is achieved, thereby obtaining the electronic assembly 1.

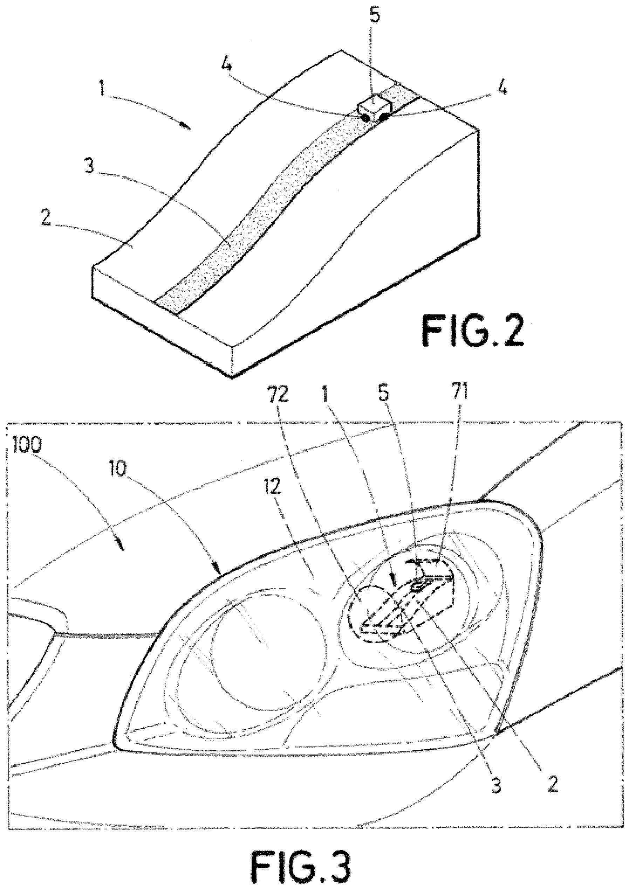

Figure 2 shows an electronic assembly 1 according to the invention. This electronic assembly comprises
a semiconductor light source 5;
a three-dimensional plastics substrate 2;
a conductive track 3 created by plasma deposition of metal dust on the three-dimensional plastics substrate 2;
a conductive welding material 4 arranged on the conductive track 3, the conductive welding material 4 being in direct contact with both the conductive track 3 and the semiconductor light source 5.

Figure 3 shows a lighting device 10 for an automotive vehicle comprising
an electronic assembly 1 as shown in figure 2;
a reflector 71, and a projection lens 72, suitable for receiving light from the light source 5 and projecting it in the shape of a light pattern in a forward direction; and
a housing 12 accommodating the electronic assembly 1, the reflector 71 and the projection lens 72.

The forward direction should be understood as the advance direction of an automotive vehicle where the lighting device is intended to be installed.

In the particular embodiment shown in this figure, the optical elements include a reflector 71 and a projection lens 72. The reflector 71 is placed over the electronic assembly 1, arranged to reflect the light emitted by the light source 5. The projection lens is in turn located in a forward position with respect to the lighting device 10, and receives the light from the light source 5 which has been reflected by the reflector 71. The projection lens 72 orientates this received light according to the vehicle advancing direction.

These optical elements 71, 72 makes the lighting device 11 suitable for being installed in an automotive vehicle 100 and able to perform lighting functions, such as high-beam and lowbeam.

The electronic assembly 1 occupies a smaller volume than the electronic assemblies of the state of the art, and that makes that the lighting device may be smaller or house more elements without the need of increasing its size.

This lighting device 10 may be incorporated in an automotive vehicle, saving space and weight, because its manufacturing require less time and a lower number of elements.

## Claims

1. Method for creating an electronic assembly (1), the method comprising the steps of:
providing a plastics substrate (2);
providing a semiconductor light source (5);
depositing a conductive track (3) by direct deposition on the plastics substrate (2);
depositing a conductive welding material (4) on the conductive track (3) or on the light source (5);
placing the light source (5) on the conductive track (3), in such a way that the conductive welding material (4) is in direct contact with both the conductive track (3) and the light source (5); and
addressing a heat source on the conductive welding material, so that an electric contact between the light source and the conductive track is achieved by means of the conductive welding material (4), thereby obtaining the electronic assembly.

2. Method according to claim 1, wherein the heat source comprises a gas flow (6), which is addressed by using a gas nozzle (7).

3. Method according to any of claims 1 or 2, wherein the plastics substrate (2) is a three-dimensional plastics substrate.

4. Method according to any of preceding claims, further comprising the step of depositing a drop of an adhesive material between the light source (5) and the conductive track (3).

5. Method according to any of preceding claims, further comprising the step of placing a barrier (8) at least partially surrounding the conductive welding material (4), the barrier (8) being intended to block any substance which is generated during the method.

6. Method according to any of preceding claims, wherein the conductive welding material (4) is either a conductive glue or a welding paste.

7. Method according to any of preceding claims, wherein the semiconductor light source (5) is a LED or a laser light.

8. Method according to any of preceding claims, wherein the step of depositing a conductive track (3) by direct deposition on the plastics substrate (2) is carried out by means of a plasma flow containing metal dust particles.

9. Electronic assembly (1) manufactured by a method according to any of preceding claims.

10. Electronic assembly (1) comprising
a semiconductor light source (5);
a plastics substrate (2);
a conductive track (3) created by direct deposition on the plastics substrate (2);
a conductive welding material (4) arranged on the conductive track (3), the conductive welding material (4) being in direct contact with both the conductive track (3) and the light source (5).

11. Electronic assembly (1) according to claim 10, wherein the conductive welding material (4) is either a conductive glue or a welding paste.

12. Electronic assembly according to any of claims 10 or 11, wherein the conductive welding material (4) comprises at least one of Cu, Al, Sn, Bi or Ag.

13. Electronic assembly according to any of claims 10 to 12, wherein the semiconductor light source (5) is a LED or a laser light.

14. Electronic assembly according to any of claims 10 to 13, wherein the plastics substrate (2) is three-dimensional.

15. Lighting device (10) for automotive vehicle (100), the lighting device (10) comprising
an electronic assembly (1) according to any of claims 9 to 14;
an optical element (71, 72) suitable for receiving light emitted by the light source (5) and for shaping the light into a light pattern projected outside the lighting device (10); and
a housing (12) accommodating the electronic assembly (1) and the optical element (71, 72).
